Europäisches Patentamt

European Patent Office

Office européen des brevets

(19)

(11) Publication number: **0 119 691**
A2

# EUROPEAN PATENT APPLICATION

(21) Application number: 84300434.2

(22) Date of filing: 25.01.84

(51) Int. Cl.³: **H 01 L 21/60,** H 01 L 23/48

(30) Priority: 15.03.83 GB 8307146

(43) Date of publication of application: 26.09.84
Bulletin 84/39

(84) Designated Contracting States: **BE DE FR IT NL**

(71) Applicant: **STANDARD TELEPHONES AND CABLES
PUBLIC LIMITED COMPANY, 190 Strand, London,
WC2R 1DU (GB)**

(72) Inventor: **Dean, Ralph Barton, 11, Hawkins Avenue,
Chelston Torquay (GB)**
Inventor: **Janessen, Adrian Perrin, Hamlyns House St.
Andrews Rd., Exwick Exeter (GB)**
Inventor: **Stone, Jennifer Karen, 10, Hillhead Park,
Brixham Devon (GB)**
Inventor: **Walker, Arthur, 36, Crownhill Rise, Torquay
Devon (GB)**

(74) Representative: **Laurence, Simon French et al, STC
Patent Department Edingburgh Way, Harlow Essex
CM20 2SH (GB)**

(54) **Bonding semiconductive bodies.**

(57) Reproduceability and reliability problems associated
with using a solder preform to bond a semiconductor laser
chip (1) to a heat sink (2) are avoided by a diffusion assisted
bonding method. Both surfaces to be bonded are coated
with relatively thick layers of gold (3,7), one of which is then
coated with a submicron thickness tin layer (5) whose sur-
face is protected from oxidation with a further coating (6) of
gold. The two components are assembled and heated to
bond them together by causing a molten gold-tin eutectic
layer to be formed which then diffuses into the gold layers
without penetrating right through them.

0119691

R.B. Dean-A.P. Janssen-
J.H. Stone-A. Walker 2-1-1-1
                                    EPC

TITLE MODIFIED
see front page

BONDING SEMICONDUCTOR BODIES

This invention relates to the bonding of semiconductive bodies to thermally conductive substrates, and finds particular though not necessarily exclusive application in the mounting of lasers on heat-sinks.

One method that has previously been used for mounting lasers on heat sinks has involved the use of a preform pellet of gold tin eutectic solder. One of the problems associated with this bonding method is that the resolidifying solder has a tendency to form a slightly raised lip at its periphery. It is believed that this lip may be caused by a local raising of the melting point the result of compositional changes in the solder occasioned by diffusion of gold into the solder from the components being united. This lip is undesirable because it can be high enough to obstruct some of the light emitted by the laser. A second problem is associated with the fact that small bubbles are found to be present in the resolidified solder. These are probably due to included gas and, if present in regions of high current density, can give rise to local hot spots which can impair laser lifetime. A third problem is associated with the fact that since the die is floated on the solder, particularly having regard to the lip obstruction problem referred to above, the precise final height of the laser above the level of the heat sink is not readily controllable.

The present invention is particularly concerned with a bonding method that avoids the use of a solder preform.

According to the present invention there is provided a method of bonding a surface of a semiconductor body to a surface of a thermally and electrically conductive substrate, characterised in that the surface of the semiconductive body is coated with a diffusion barrier layer which is itself coated with a layer of gold, wherein the surface of the substrate is coated with a layer of gold, wherein either or both of said layers of gold are coated with a submicron thickness diffusion layer of metal or alloy that will form or is a metal-gold eutectic with a melting point at a temperature sustainable by the semiconductor body, which diffusion layer, in the case of a material that oxidises, is protected from oxidation by a protective gold coating, wherein the two coated surfaces are held together while the assembly is heated to a temperature to cause the formation of a continuous molten metal-gold eutectic layer covering the area of the bond which layer diffuses entirely into the gold of said gold layers without penetrating right through these layers, whereby a diffusion assisted metallic bond is formed between the two surfaces.

There follows a description of the bonding of a semiconductor laser chip to a substrate using a method embodying the invention in a preferred form. The description refers to the accompanying drawings in which:

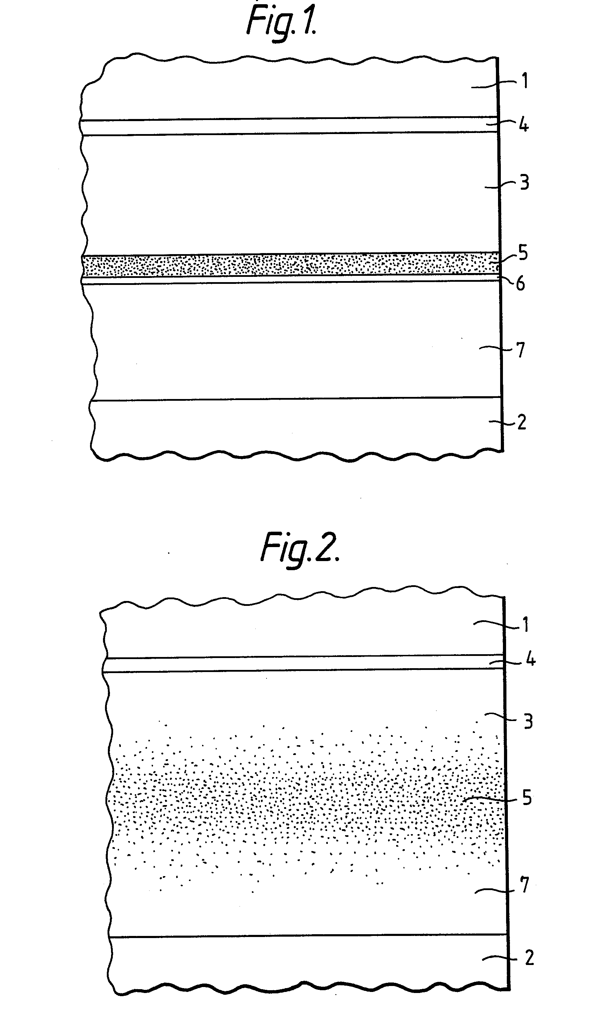

Figure 1 depicts a schematic cross-section of the assembly of chip and substrate prior to bonding, and

Figure 2 depicts the same cross-section after bonding.

A semiconductor chip 1, which may for instance be a GaAlAs or an (Ga In As P) laser, is required to be bonded to a substrate 2 which is used for making one of the electrical connections with the laser and for extracting heat from it, and may for instance be made of metallised diamond, silicon or germanium.

The surface of the laser chip which is to be bonded to the substrate is covered with an evaporated layer 3 of gold, but before this is applied a conventional diffusion barrier layer 4, for instance of palladium or platinum, is provided to prevent diffusion of the gold into the laser material. The gold layer 3 is somewhat thicker than is conventionally provided for soldering purposes, and is typically about 2 microns thick so as to be deep enough to allow metal to diffuse into it during the subsequent bonding process without penetrating right through it.

Covering the gold layer 3 is a submicron thickness layer 5 of tin deposited by evaporation. Typically this is about 0.2 microns thick and, since tin is a metal that readily oxidises, the exposed surface of this layer is protected from oxidation by a protective coating 6 of gold. This protective layer is typically only 0.02 microns thick.

The substrate 2 is also covered with an evaporated layer 7 of gold which is of similar thickness to that of layer 3 since it is required to perform the same function of allowing the metal of layer 5 to diffuse into the bonding process without diffusing right through it. A non-metallic substrate material such as diamond will typically need to be metallised to improve the bonding of the gold layer 7. For this reason a diamond substrate may be metallised with a layer of titanium (not shown) to improve bonding, and this layer may be covered with a further layer (not shown) of platinum to prevent the titanium from subsequently diffusing into the gold. Clearly, since no solder is being employed, the substrate surface flatness needs to be of good quality, and with diamond this quality is readily achievable by cleaving.

Tin is one of the preferred materials for the diffusion layer 5 since tin forms a relatively low temperature eutectic with gold at $283^{\circ}$C which is well below temperatures in the region of $400^{\circ}$C at which the laser is beginning to be susceptible to sustaining damage from internal diffusion effects. The laser chip is placed in position on the substrate and lightly clamped in position, for instance with a needle tip exerting a force of about 0.2 N. The assembly is heated up to about $300^{\circ}C$ over a period typically of several minutes, is sustained at this temperature typically for not more than half a minute, and allowed to cool naturally to room temperature in a further period of typically 5 to 10 minutes. This heating schedule causes the tin of layer 5 to react with some of the gold of layers 3 and 7 and form a continuous molten eutectic layer covering the area of the bond. This molten layer then diffuses entirely into the layers 3 and 7 without diffusing right through them to penetrate as far as the barrier layer 4 on the substrate 2.

Examination of a number of bonds made by this method have revealed a significantly reduced defect density, the presence of a bond of high reliability, and more precisely controlled geometry than bonds made by the solder preform method referred to previously. Moreover, the thermal impedance is low due to the small bond thickness and low defect density.

It will be evident that the diffusion layer 5 could alternatively have been applied to the substrate instead of to the laser chip, or a reduced thickness diffusion layer could have been applied to both elements. It will also be evident that the diffusion layer could have incorporated some gold with the tin so as to reduce or eliminate the requirement to extract gold from layers 3 and 7 to form the eutectic.

An example of an alternative metal to tin for the diffusion layer 5 is germanium. Germanium forms a higher temperature eutectic with gold than the tin gold eutectic, but the temperature is not too high to be used for bonding chips of GaAlAs and (Ga In As P), and the more simple phase diagram of this eutectic may confer advantages in the quality of the resulting bond.

CLAIMS:-

1. A method of bonding a surface of a semiconductor body (1) to a surface of a thermally and electrically conductive substrate (2), characterised in that the surface of the semiconductive body is coated with a diffusion barrier layer (4) which is itself coated with a layer (3) of gold, wherein the surface of the substrate is coated with a layer (7) of gold, wherein either or both of said layers (3, 7) of gold are coated with a submicron thickness diffusion layer (5) of metal or alloy that will form or is a metal-gold eutectic with a melting point at a temperature sustainable by the semiconductor body, which diffusion layer, in the case of a material that oxidises, is protected from oxidation by a protective gold coating (6), wherein the two coated surfaces are held together while the assembly is heated to a temperature to cause the formation of a continuous molten metal-gold eutectic layer covering the area of the bond which layer diffuses entirely into the gold of said gold layers without penetrating right through these layers, whereby a diffusion assisted metallic bond is formed between the two surfaces.

2. A method as claimed in claim 1, wherein the diffusion layer is made of tin or includes tin as a constituent.

3. A method as claimed in claim 1, wherein the diffusion layer is made of germanium or includes germanium as a constituent.

4. A method as claimed in claim 1, 2 or 3, wherein the diffusion layer is made of elemental metal.

5. A method as claimed in claim 1, 2, 3 or 4, wherein the semiconductive body is a laser.

6. A method as claimed in claim 1, 2, 3, 4 or 5, wherein the semiconductive body is made of GaAlAs.

7. A method as claimed in claim 1, 2, 3, 4 or 5, wherein the semiconductive body is made of (Ga In As P).

8. A semiconductor body which has been bonded to a substrate by the method claimed in any preceding claim.

**Fig.1.**

**Fig.2.**